# EUROPÄISCHE PATENTSCHRIFT

(11) **EP 2 644 419 B1**
(45) Veröffentlichungstag und Bekanntmachung des Hinweises auf die Patenterteilung: **10.07.2019**
(21) Anmeldenummer: 13161180.8
(22) Anmeldetag: 26.03.2013
(51) Int. Cl.: B60H 1/00, H05K 7/20

(54) **Fahrzeug mit einem Gehäuse zur Aufnahme und Temperaturregulierung einer elektronischen Einrichtung**
Vehicle equipped with a housing for holding and regulating the temperature of an electronic device
Véhicule doté d'un boîtier de réception et régulation de la température d'un dispositif électronique

(30) Priorität: 27.03.2012 DE 102012204892
(43) Veröffentlichungstag der Anmeldung: 02.10.2013
(73) Patentinhaber: MEKRA Lang GmbH & Co. KG, 90765 Fürth (DE)
(72) Erfinder: Lang, Werner Dr., 91465 Ergersheim (DE); Bauer, Stefan Dr., 91466 Gerhardshofen (DE); Deffner, Simon, 91604 Flachslanden (DE); Heger, Sebastian, 91438 Bad Windsheim (DE); Zink, Matthias, 91620 Ohrenbach (DE)
(74) Vertreter: Winter, Brandl, Fürniss, Hübner, Röss, Kaiser, Polte - Partnerschaft mbB

(56) Entgegenhaltungen:
- DE-A1-102004 028 740
- DE-A1-102007 032 852
- DE-B3- 10 359 064
- JP-A- S63 155 488
- US-A1- 2005 012 039

## Beschreibung

Die vorliegende Erfindung betrifft ein Fahrzeug mit einem Gehäuse zur Aufnahme und Temperaturregulierung (Temperierung) einer elektronischen Einrichtung, wobei das Gehäuse insbesondere an einer vorbestimmten Position in einer Fahrgastzelle des Fahrzeugs angeordnet ist.

Elektronische Einrichtungen arbeiten nur dann zuverlässig, wenn sie sich auf ihrer jeweiligen Betriebstemperatur befinden, wobei mit Betriebs'temperatur' ein Temperatur'bereich' gemeint ist, in dem die elektronische Einrichtung optimal, d. h. ohne Schaden zu nehmen und mit hohem Wirkungsgrad arbeitet. Insbesondere bei einer elektronischen Einrichtung, die in der Fahrgastzelle eines Kraftfahrzeugs angeordnet ist und der Fahrsicherheit dient, ist ein zuverlässiges Funktionieren unabdingbar. Eine Temperaturregulierungsvorrichtung muss dies auch in Extremsituationen, z. B. im Sommer, wenn das Fahrzeug längere Zeit der Sonne ausgesetzt ist und die Temperatur der Fahrgastzelle sehr hoch ist, gewährleisten. Entsprechendes gilt - mutatis mutandis - im umgekehrten Fall, wenn die Temperatur in der Fahrgastzelle und damit die der elektronischen Einrichtung unter ihre Betriebstemperatur sinken kann.

Ein Fahrzeug gemäß dem Oberbegriff des Anspruchs 1 ist in der DE 10 2004 028740 A1 offenbart. Zum besseren Verständnis der vorliegenden Erfindung sei ferner auf die DE 103 59 064 B3, die US 2005/012039 A1 und die DE 10 2007 032852 A1 verwiesen.

Es ist eine Aufgabe der vorliegenden Erfindung, ein Fahrzeug mit einem Gehäuse Gehäuse zur Aufnahme und Temperaturregulierung einer elektronischen Einrichtung bereitzustellen, wobei zur Regulierung der Temperatur in ökonomischer Weise ausschließlich auf bereits vorhandene Ressourcen des Fahrzeugs zurückgegriffen werden soll.

Diese Aufgabe wird durch die Merkmale des Anspruchs 1 gelöst. Weitere vorteilhafte Ausgestaltungen sind in den Unteransprüchen definiert.

Gemäß der vorliegenden Erfindung umfasst ein Fahrzeug eine Fahrgastzelle, eine Klimaanlage, die dazu geeignet ist, temperierte Luftströme in der Fahrgastzelle zu erzeugen, ein Gehäuse, das wenigstens eine Lufteinlassöffnung, die mit einem Luftkanal der Klimaanlage strömungstechnisch verbunden ist, und wenigstens eine Luftauslassöffnung zum Durchströmen des Gehäuses mit einem temperierten Luftstrom umfasst, und eine elektronische Einrichtung, die in dem Gehäuse aufgenommen ist und von dem temperierten Luftstrom umströmbar ist . Das Fahrzeug ist dadurch gekennzeichnet, dass die Temperierung eine Kühlung und eine Erwärmung umfasst, zur Temperierung der elektronischen Einrichtung ausschließlich die durch Temperaturregulierung mittels der Klimaanlage temperierten Luftströme verwendet werden, die das Gehäuse durchströmen, und die elektronische Einrichtung ein indirektes Sichtsystem ist, das in der Fahrgastzelle im Sichtfeld eines Fahrers des Fahrzeugs angeordnet ist.

Erfindungsgemäß erfolgt die Temperierung somit ausschließlich entweder durch Kühlen oder Erwärmen von Luftströmen von der und durch die Klimaanlage oder durch Regulierung der Strömungsrate oder Luftmasse pro Zeiteinheit dieser Luftströme, die durch Konvektion Wärme zu oder von der elektronischen Einrichtung transportieren. Zu diesem Zweck wird vorzugsweise ein temperierter, d. h. gekühlter oder erwärmter, Luftstrom durch das Gehäuse geleitet. Es ist zu beachten, dass der Ausdruck 'Regulierung' ist hier als Oberbegriff sowohl für eine Regelung als auch für eine Steuerung (d. h. eine manuelle Vorgabe einer Temperatur) zu verstehen ist. Es ist zu beachten, dass die vorliegende Erfindung sowohl in die Entwicklungsphase eines Neuwagens einfließen oder zur Nachrüstung eines bereits vorhandenen Fahrzeugs verwendet werden kann. Die wirksame Temperierung der elektronischen Einrichtung erfolgt somit durch das Zusammenwirken von (a) den von der Klimaanlage gelieferten und durch sie temperierten Luftströmen, (b) dem Gehäuse, das den Luftstrom durch und/oder um die elektronische Einrichtung leitet, und (c) der Anordnung (Position und Orientierung) der elektronischen Einrichtung, durch die die Regulierung mit einem hohen Wirkungsgrad und unter möglichst geringer Auslastung der Fahrzeugressourcen erfolgt. Der Ausdruck 'ausschließlich' bedeutet hier insbesondere, dass das Gehäuse keine Regulierungsmittel wie Klappen oder Blenden oder dergleichen umfasst. Daher bedeutet das Merkmal, dass ,eine Temperaturregulierung der elektronischen Einrichtung ausschließlich durch die Temperaturregulierung mittels der Klimaanlage erfolgt', dass das Gehäuse nicht ein Teil der Klimaanlage ist, sondern dasjenige Objekt, das durch sie temperiert wird.

Gemäß der vorliegenden Erfindung ist ein Luftkanal der Klimaanlage mit dem Gehäuse fest verbunden und das Gehäuse wird von außen von dem Luftstrom angeströmt. Der Vorteil der ersten vorteilhaften Ausgestaltung liegt in der höheren Effizienz der Kühlung / Erwärmung, da der gesamte (100 %) aus dem Luftkanal austretende Luftstrom in das Gehäuse gelangt und zur Temperaturregulierung der elektronischen Einrichtung zur Verfügung steht. Der Vorteil der zweiten vorteilhaften Ausgestaltung ist ein konstruktiver und damit auch finanzieller, denn der Luftschacht muss sich in diesem Fall nicht bis zu dem Gehäuse erstrecken, zwischen dem Ende des Luftschachts (der Austrittsstelle des Luftstroms in die Fahrgastzelle) und dem Gehäuse besteht ein Abstand. Vorzugsweise ist das Ende des Luftkanals mit einer geeigneten Düse versehen, die (a) die Richtung und (b) die Strömungscharakteristik des Luftstroms bestimmt, so dass die Position (durch (a)) des Gehäuses innerhalb der Fahrgastzelle flexibel, und der Wirkungsgrad der Kühlung/Erwärmung optimierbar (z. B. durch (b)) ist. Wie es oben erwähnt ist, sind Faktoren, die Einfluss auf den Wirkungsgrad der Kühlung/Erwärmung haben, z. B. die Temperatur, die Strömungsgeschwindigkeit des Luftstroms und die Gestaltung des Gehäuses (siehe unten).

Gemäß der vorliegenden Erfindung ist die elektronische Einrichtung ein indirektes Sichtsystem ist, das im Sichtfeld eines Fahrers des Fahrzeugs angeordnet. Wie es oben bereits erwähnt ist, ist das indirekte Sichtsystem dazu geeignet, einen herkömmlichen Rückblickspiegel zu ersetzen oder zu ergänzen. Vorzugsweise ist das indirekte Sichtsystem mit wenigstens einer In-Vehicle- oder Bordkamera verbunden, die ein vorbestimmtes Sichtfeld abbildet. Ist das indirekte Sichtsystem mit mehreren solcher Kameras verbunden, so ist es vorteilhafterweise entweder zwischen den einzelnen Sichtfeldern umschaltbar, oder die mehreren Sichtfelder werden nebeneinander auf einem Display des indirekten Sichtsystems dargestellt. Alternativ kann die elektronische Einrichtung ein Navigationsgerät sein oder zusätzlich zu dem indirekten Sichtsystem umfassen

Gemäß der vorliegenden Erfindung ist ein Luftkanal der Klimaanlage mit der wenigstens einen Lufteinlassöffnung strömungstechnisch verbunden ist. Der Luftkanal erstreckt sich bis zu dem Gehäuse und ist mit diesem dicht verbunden. Vorzugsweise weist das Gehäuse in diesem Fall nur eine Lufteinlassöffnung auf, deren Größe an die Größe des Endes des Luftkanals angepasst ist. Wie es oben bereits erwähnt ist, wird auf diese Weise der gesamte Luftstrom in das Gehäuse eingekoppelt und zur Temperaturregulierung verwendet. Da die dabei übertragene Wärmemenge maximal ist, ist der Wirkungsgrad 100 %.

Gemäß einer vorteilhaften Ausgestaltung der vorliegenden Erfindung befindet sich die vorbestimmte Position in einer A-Säule des Fahrzeugs. Unabhängig von der Funktion der elektronischen Einrichtung besteht der Vorteil dieser Position darin, dass üblicherweise bereits Luftkanäle vorgesehen sind, die sich bis zu den seitlichen Enden des Armaturenbretts bzw. dessen Abdeckung erstrecken und den Luftstrom üblicherweise auf die Windschutzscheibe und/oder eine Seitenscheibe des Fahrzeugs lenken. Dieser Vorteil kommt insbesondere dann zum Tragen, wenn das Gehäuse, wie oben erwähnt, von außen von dem Luftstrom angeströmt wird, denn die vorhandene A-Säule muss hierzu lediglich entweder so verändert werden, dass das Gehäuse darin aufgenommen werden kann (die oben erwähnte Entwicklungsphase), oder gegen eine speziell zu diesem Zweck ausgebildete A-Säule ausgetauscht werden (die oben erwähnte Nachrüstung). Alternativ kann die A-Säule für einen optionalen, späteren Einbau des erfindungsgemäßen Gehäuses vorbereitet sein. Die Klimaanlage muss entweder gar nicht verändert werden oder nur durch Austausch der Düsen zur besseren Anströmung des Gehäuses. Ferner ist lediglich eine geeignete Verlängerung des Luftkanals erforderlich, wenn der Luftkanal der Klimaanlage mit dem Gehäuse fest verbunden ist. Dadurch ist eine Nachrüstung eines Fahrzeugs mit dem erfindungsgemäßen Gehäuse bzw. ein Umbau eines Fahrzeugs zu dem erfindungsgemäßen Fahrzeug sehr kostengünstig. Wie es weiter unten ausgeführt ist, ist es möglich, dass die elektronische Einrichtung eine LCD- oder eine andere Anzeige umfasst. In einem solchen Fall ist die Position des Gehäuses in der A-Säule vorteilhaft, da die darauf angezeigte Information sowohl vom Fahrer als auch vom Beifahrer erkannt werden kann. In welcher der beiden A-Säulen das Gehäuse angeordnet ist, hängt auch von der elektronischen Einrichtung selbst ab. Ist die elektronische Einrichtung zum Beispiel ein Monitor, der einen herkömmlichen Rückblickspiegel dahingehend ergänzt, dass er einen Blick in den toten Winkel gewährt, so ist das Gehäuse vorzugsweise in der rechten A-Säule angeordnet, da der tote Winkel auf der linken Seite des Fahrzeugs leicht durch Drehen des Kopfes eingesehen werden kann. Vorteilhafterweise kann in der A-Säule eine entsprechende Aussparung vorhanden sein oder erzeugt werden, in die das Gehäuse eingepasst wird, oder das Gehäuse kann gewissermaßen als A-Säule ausgebildet sein, also eine Vertiefung aufweisen, in der die elektronische Einrichtung platziert werden kann.

Gemäß einer weiteren vorteilhaften Ausgestaltung der vorliegenden Erfindung befindet sich die vorbestimmte Position am Armaturenbrett des Fahrzeugs. Auch diese Position befindet sich vorteilhafterweise in unmittelbarer Nähe zu normalerweise bereits vorhandenen Luftkanälen, so das zu der vorteilhaften Ausgestaltung gemäß Anspruch 4 der vorliegenden Erfindung Gesagte hier ebenfalls Gültigkeit besitzt.

Gemäß einer weiteren vorteilhaften Ausgestaltung der vorliegenden Erfindung ist das Gehäuse integral mit einem Element des Fahrzeugs verbunden, während es gemäß einer weiteren vorteilhaften Ausgestaltung der vorliegenden Erfindung lösbar mit einem Element des Fahrzeugs verbunden ist. Ein 'Element' des Fahrzeugs ist erfindungsgemäß vorzugsweise eine Blende einer A-Säule oder die Armaturenbrettabdeckung des Fahrzeugs. Die Formulierung ,das Gehäuse ist integral mit einem Element des Fahrzeugs verbunden' ist erfindungsgemäß als Gegensatz zu 'lösbar' zu verstehen. Das heißt, das Gehäuse und das Element sind einteilig oder einstückig, zum Beispiel durch eine Spritzgussverfahren oder dergleichen, miteinander verbunden. Ferner ist das Gehäuse ,lösbar' mit dem Element verbunden, wenn es entweder (a) mit Hilfe eines geeigneten Werkzeugs zerstörungsfrei an dem Element befestigt und von dem Element entfernt / demontiert werden kann, zum Beispiel zum Zweck der Reparatur oder Wartung, oder (b) steckbar, einrastbar, oder dergleichen an dem Element befestigt werden kann. Ist das Gehäuse etwa über der Mittelkonsole an der Armaturenbrettabdeckung befestigt und ist in ihm eine elektrische Einrichtung mit einem Display aufgenommen, so ist es vorteilhaft, wenn die Verbindung drehbar ist, so dass das Display entweder zu dem Fahrer oder zu dem Beifahrer ausgerichtet werden kann. In einer vorteilhaften Ausgestaltung werden in diesem Fall, bewirkt zum Beispiel durch das Drehen des Gehäuses, automatisch unterschiedliche Luftkanäle ausgewählt, so dass das Gehäuse in jeder Position optimal angeströmt wird. Im Falle einer direkten Verbindung zwischen dem Luftkanal und dem Gehäuse ist ein solcher Mechanismus nicht erforderlich. Alternativ ist es möglich, das Gehäuse so auszugestalten, dass es gleich effektiv von verschiedenen Seiten durchströmt werden kann, so dass nur ein Luftkanal benötigt wird, der in den zwei Ausrichtungen des Gehäuses auf unterschiedliche Oberflächen mit entsprechender Ausgestaltung auftrifft.

Gemäß einer weiteren vorteilhaften Ausgestaltung der vorliegenden Erfindung ist eine Innentemperatur des Gehäuses eine Regelgröße zur Einstellung der Betriebstemperatur. Die in Anspruch 1 definierte Temperaturregulierung ist somit insbesondere als Regelung konkretisiert, in der z. B. die Strömungsgeschwindigkeit oder die Temperatur des Luftstroms Stellgrößen sind. Wie aus den bisherigen Ausführungen folgt, ist es das Ziel, die Temperatur der elektronischen Einrichtung zu regulieren, wobei das Gehäuse, in dem die elektronische Einrichtung aufgenommen ist, als ,Strömungsleitmittel' verwendet wird. Da die Temperatur des Gehäuses von mehreren Faktoren wie etwa der Position des Gehäuses in der Fahrgastzelle, den Witterungsverhältnisses, d. h. insbesondere der Sonneneinstrahlung, der Isolation und Oberflächenbeschichtung des Gehäuses abhängt, wird für eine zuverlässige Temperaturregulierung vorzugsweise die Innentemperatur des Gehäuses erfasst und als Regelgröße des Regelkreises verwendet. Vorteilhafterweise ist dabei ein hierzu erforderlicher Temperatursensor im Strömungsschatten der elektronischen Einrichtung angeordnet, so dass Fehlmessungen durch eine Hysterese möglichst vermieden werden (der Sensor kann möglicherweise im Luftstrom schneller gekühlt / erwärmt werden als die elektronische Einrichtung). Vorteilhafterweise wird der Sensor an einer besonders temperatursensiblen Stelle der elektronischen Einrichtung angeordnet.

Gemäß einer weiteren vorteilhaften Ausgestaltung der vorliegenden Erfindung ist die wenigstens eine Luftauslassöffnung so angeordnet ist, dass der aus dem Gehäuse ausströmende Luftstrom wenigstens eine Scheibe des Fahrzeugs anströmt. Gemäß dieser vorteilhaften Ausgestaltung wird der Luftstrom durch das Gehäuse geführt und in ihm umgelenkt, so dass er auf die Scheibe auftrifft. Die Scheibe ist insbesondere die Windschutzscheibe und/oder ein Seitenfenster des Fahrzeugs. In einer Situation zum Beispiel, in der das Fahrzeug nach längerem Stillstand bei einer Außentemperatur - und somit im Wesentlichen auch Innentemperatur - des Fahrzeugs von weit unter 0 °C gestartet wird, ist es für die Fahrsicherheit u. U. wichtig, zuerst die elektronische Einrichtung auf Betriebstemperatur zu bringen (diese hat Priorität), indem z. B. der Luftstrom, der in das Gehäuse geleitet wird, stärker erwärmt wird als der Luftstrom der direkt ins Innere der Fahrgastzelle gelenkt wird ohne durch das Gehäuse zu strömen. Da, um ein möglichst schnelles Erreichen der Betriebstemperatur zu gewährleisten, die Temperatur des Luftstroms möglichst hoch (nicht höher als die Obergrenze des Betriebstemperaturbereichs) gewählt wird, ist die Temperatur des Luftstroms nach Durchströmen des Gehäuses trotz Wärmeabgabe an die elektronische Einrichtung immer noch höher als die Temperatur des Luftstroms zur allgemeinen Erwärmung der Fahrgastzelle. Diese relativ hohe Temperatur des Luftstroms, der auf eine Scheibe des Fahrzeugs gerichtet ist, hat den Vorteil, dass die Sicht durch die jeweils angeströmte Scheibe sehr schnell verbessert ist.

Gemäß einer weiteren vorteilhaften Ausgestaltung der vorliegenden Erfindung besitzt die wenigstens eine Lufteinlassöffnung einen Querschnitt, der sich ins Innere des Gehäuses verkleinert. Dies hat den Vorteil, dass ein möglichst großer Teil des Luftstroms "eingefangen" und ins Innere des Gehäuses gelenkt wird (Trichterwirkung), wobei der Querschnitt vorteilhafterweise so ausgebildet ist, dass im Inneren des Gehäuses eine Luftklinge laminarer Strömung gebildet wird. Vorteilhafterweise kann die wenigstens eine Lufteinlassöffnung so bezüglich des Gesamtgehäuses orientiert sein, dass der Luftstrom die elektronische Einrichtung optimal umströmt oder dass der Luftstrom bevorzugt auf temperatursensible Abschnitte der elektronischen Einrichtung gerichtet ist.

Gemäß einer weiteren vorteilhaften Ausgestaltung der vorliegenden Erfindung sind mehrere Lufteinlassöffnungen entlang eines Randes des Gehäuses angeordnet. Vorteilhafterweise befindet sich zwischen der elektronischen Einrichtung und dem Gehäuse ein Spalt, als Teil des Strömungsweges des das Gehäuse durchströmenden Luftstroms, und die mehreren Lufteinlassöffnungen sind entlang des Spaltes = entlang des Randes des Gehäuses angeordnet, so dass eine optimale Umströmung der elektronischen Einrichtung erreicht wird.

Gemäß einer weiteren vorteilhaften Ausgestaltung der vorliegenden Erfindung ist die elektronische Einrichtung fest in dem Gehäuse integriert, während gemäß einer weiteren vorteilhaften Ausgestaltung der vorliegenden Erfindung das Gehäuse als Dockingstation ausgebildet ist und die elektronische Einrichtung eine mobile Einrichtung ist, die mit der Dockingstation koppelbar ist. Die Herausnehmbarkeit der mobilen elektronischen Einrichtung bedeutet gleichermaßen Austauschbarkeit und Diebstahlsicherung. Austauschbarkeit wiederum bedeutet, dass das System modular genutzt werden kann. Vorteilhafterweise können mehrere Menschen, die das Fahrzeug abwechselnd nutzen, jeweils ihre persönliche elektronische Einrichtung einsetzen, die persönliche Daten und Einstellungen enthält.

Weitere Vorteile und Merkmale der vorliegenden Erfindung werden ersichtlich aus der nachfolgenden Beschreibung mit Bezug auf die beigefügten Zeichnungen. In den Zeichnungen sind:
Fig. 1 ein Teil eines Fahrzeugs mit einem Gehäuse gemäß einer ersten Ausführungsform der vorliegenden Erfindung;
Fig. 2 ein Teil eines Fahrzeugs mit einem Gehäuse gemäß einer zweiten Ausführungsform der vorliegenden Erfindung;
Fig. 3 ein Teil eines Fahrzeugs mit einem Gehäuse gemäß einer dritten Ausführungsform der vorliegenden Erfindung; und
Fig. 4 ein Teil eines Fahrzeugs mit einem Gehäuse gemäß einer vierten Ausführungsform der vorliegenden Erfindung.

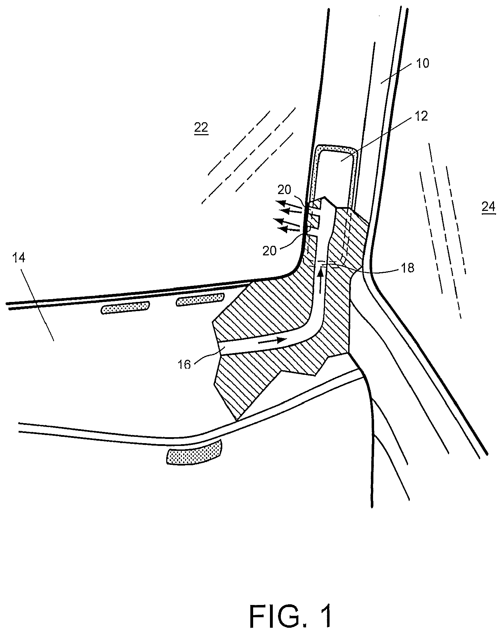

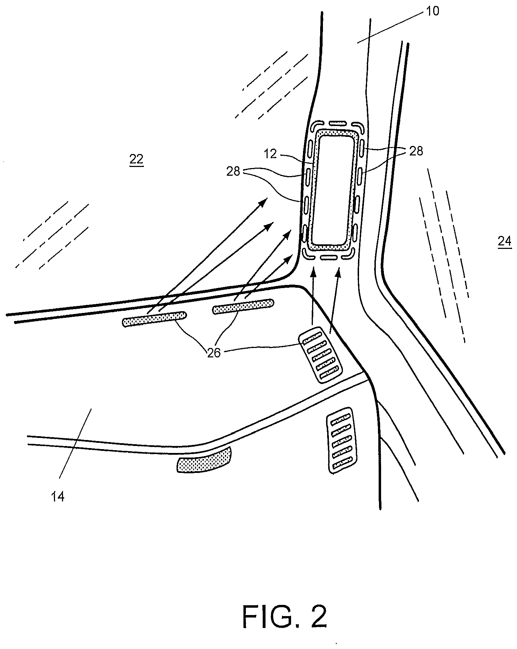

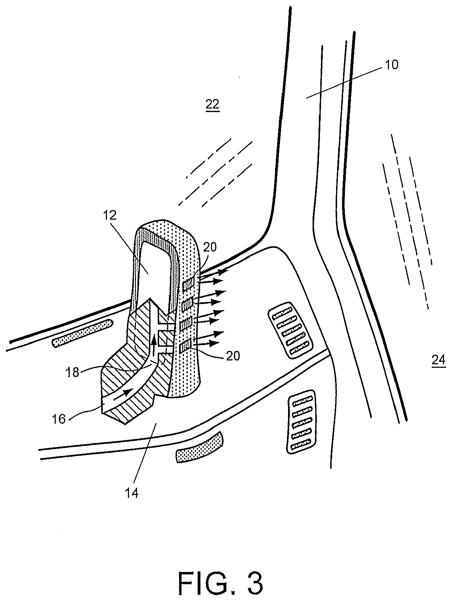

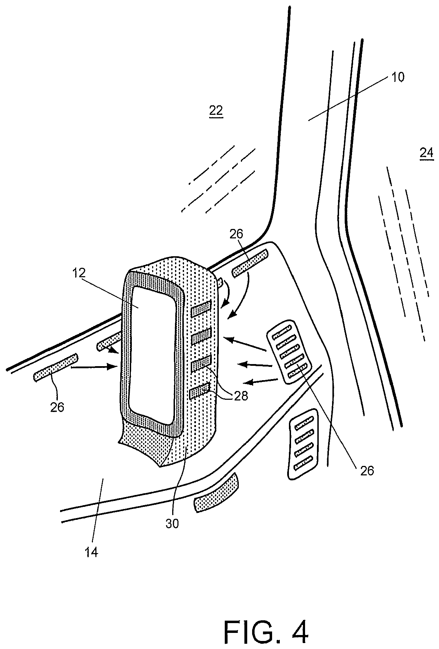

Die Fign. 1 und 2 zeigen jeweils ein in einer A-Säule 10 eines Fahrzeugs (nur der Bereich um das untere Ende der A-Säule ist dargestellt) eingebautes Gehäuse 12, in dem eine elektronische Einrichtung (nicht gezeigt) aufgenommen ist. Die Fign. 3 und 4 zeigen jeweils das an einer Armaturenbrettabdeckung 14 befestigte Gehäuse 12.

Die Fign. 1 und 3 zeigen jeweils einen Luftkanal 16 als Teil einer Klimaanlage (nicht gezeigt) des Fahrzeugs, der strömungstechnisch dicht mit dem Gehäuse 12 verbunden ist. Der über den Luftkanal 16 in das Gehäuse 12 eingeleitete Luftstrom strömt an einer Lufteinlassöffnung 18 in das Gehäuse 12 ein und verlässt das Gehäuse 12 durch mehrere Luftauslassöffnungen 20. Wie es in den Fign. 1 und 3 zu erkennen ist, strömt die Luft zum einen in Richtung der Windschutzscheibe 22 (Fig. 1) und zum anderen in Richtung einer Seitenscheibe 24 durch die Luftauslassöffnungen 20 aus dem Gehäuse 12 aus. Wie es in Fig. 3 zu erkennen ist, ist gemäß dieser Ausführungsform das Gehäuse 12 integral mit der Armaturenbrettabdeckung 14 verbunden.

Die Fign. 2 und 4 zeigen jeweils eine Ausführungsform, in der zwischen dem Luftkanal 16 und dem Gehäuse 12 ein Abstand besteht, das Gehäuse 12 also von dem Luftstrom angeströmt wird; der Luftstrom wird nicht direkt in das Gehäuse 12 eingekoppelt wie im Falle der in den Fign. 1 und 3 dargestellten Ausführungsform. Der Luftstrom entstammt Düsen 26, die Enden des Luftkanals 16 oder mehrere Luftkanäle 16 der Klimaanlage bilden und den Luftstrom in definierter Weise zu dem Gehäuse 12 lenken. Lufteinlassöffnungen 28 sind in Fig. 2 entlang eines Teils des Umfangs des Gehäuses 12 und in Fig. 4 an Seitenflächen 30 (nur auf einer Seitenfläche sichtbar) ausgebildet. Wie es durch Vergleich der Fign. 3 und 4 ersichtlich ist, ist das Gehäuse 12 in der Ausführungsform der Fig. 4 nicht integral mit der Armaturenbrettabdeckung 14 verbunden, sondern lösbar an ihr befestigt.

Es ist zu beachten, dass keines der Gehäuse 12 gemäß der Ausführungsformen 1 bis 4 mit einem Mittel ausgestattet ist, das dazu geeignet wäre, einen Beitrag zur Temperaturregulierung der elektronischen Einrichtung zu liefern.

### Bezugszeichenliste

- 10: A-Säule
- 12: Gehäuse
- 14: Armaturenbrettabdeckung
- 16: Luftkanal
- 18: Lufteinlassöffnung
- 20: Luftauslassöffnung
- 22: Windschutzscheibe
- 24: Seitenfenster
- 26: Düsen
- 28: Lufteinlassöffnung
- 30: Seitenfläche von 12

## Patentansprüche

1. Fahrzeug mit:
- einer Fahrgastzelle;
- einer Klimaanlage, die dazu geeignet ist, temperierte Luftströme in der Fahrgastzelle zu erzeugen; und
- einem Gehäuse (12), das wenigstens eine Lufteinlassöffnung (18), die mit einem Luftkanal (16) der Klimaanlage strömungstechnisch verbunden ist, und wenigstens eine Luftauslassöffnung (20) zum Durchströmen des Gehäuses (12) mit einem temperierten Luftstrom umfasst;
- einer elektronischen Einrichtung, die in dem Gehäuse (12) aufgenommen ist und von dem temperierten Luftstrom umströmbar ist,
**dadurch gekennzeichnet, dass**:
- die Temperierung eine Kühlung und eine Erwärmung umfasst;
- zur Temperierung der elektronischen Einrichtung ausschließlich die durch Temperaturregulierung mittels der Klimaanlage temperierten Luftströme verwendet werden, die das Gehäuse (12) durchströmen; und
- die elektronische Einrichtung ein indirektes Sichtsystem ist, das an einer vorbestimmten Position in der Fahrgastzelle im Sichtfeld eines Fahrers des Fahrzeugs angeordnet ist.

2. Fahrzeug nach Anspruch 1, **dadurch gekennzeichnet, dass** sich die vorbestimmte Position in einer A-Säule (10) des Fahrzeugs befindet.

3. Fahrzeug nach 3 Anspruch 1 oder 2, **dadurch gekennzeichnet, dass** sich die vorbestimmte Position am Armaturenbrett des Fahrzeugs befindet.

4. Fahrzeug nach einem der Ansprüche 1 bis 3, **dadurch gekennzeichnet, dass** das Gehäuse (12) integral mit einem Element des Fahrzeugs verbunden ist.

5. Fahrzeug nach einem der Ansprüche 1 bis 4, **dadurch gekennzeichnet, dass** das Gehäuse (12) lösbar mit einem Element des Fahrzeugs verbunden ist.

6. Fahrzeug nach einem der Ansprüche 1 bis 5, **dadurch gekennzeichnet, dass** eine Innentemperatur des Gehäuses (12) eine Regelgröße zur Einstellung der Betriebstemperatur ist.

7. Fahrzeug nach einem der Ansprüche 1 bis 6, **dadurch gekennzeichnet, dass** die wenigstens eine Luftauslassöffnung (20) so angeordnet ist, dass der aus dem Gehäuse (12) ausströmende Luftstrom wenigstens eine Scheibe (22, 24) des Fahrzeugs anströmt.

8. Fahrzeug nach einem der Ansprüche 1 bis 7, **dadurch gekennzeichnet, dass** die wenigstens eine Lufteinlassöffnung (18) einen Querschnitt besitzt, der sich ins Innere des Gehäuses (12) verkleinert.

9. Fahrzeug nach Anspruch 8, **dadurch gekennzeichnet, dass** mehrere Lufteinlassöffnungen (18) entlang eines Randes des Gehäuses (12) angeordnet sind.

10. Fahrzeug nach Anspruch 8 oder 9, **dadurch gekennzeichnet, dass** die elektronische Einrichtung fest in dem Gehäuse (12) integriert ist.

11. Fahrzeug nach einem der Ansprüche 8 bis 10, **dadurch gekennzeichnet, dass** es das Gehäuse als Dockingstation ausgebildet und die elektronische Einrichtung eine mobile Einrichtung ist, die mit der Dockingstation koppelbar ist.

## Claims

1. Vehicle comprising:
- a passenger compartment;
- an air conditioning system adapted to create temperature-regulated air currents within the passenger compartment; and
- a housing (12) comprising at least one air inlet (18), which is fluidly connected to an air duct (16) of the air conditioning system, and at least one air outlet (20) for passing a temperature-regulated air current through the housing (12),
- an electronic device accommodated in the hosing (12) around which the temperature-regulated air current can be passed,
**characterized in that**:
- the temperature-regulation includes cooling and heating;
- the air currents passing through the housing (12) which are temperature-regulated via temperature-regulation by means of the air conditioning system are used exclusively for temperature-regulation of the electronic device,
- the electronic device is an indirect vision system, located at a predetermined position within the passenger compartment in the field of view of a driver of the vehicle.

2. Vehicle according to claim 1, **characterized in that** the predetermined position is in an A-pillar (10) of the vehicle.

3. Vehicle according to claim 1 or 2, **characterized in that** the predetermined position is on a dashboard panel (14) of the vehicle.

4. Vehicle according to one of the claims 1 to 3, **characterized in that** the housing (12) is connected integrally to an element of the vehicle.

5. Vehicle according to one of the claims 1 to 4, **characterized in that** housing (12) is connected detachably to an element of the vehicle.

6. Vehicle according to one of the claims 1 to 5, **characterized in that** an inside temperature of the housing (12) is a controlled variable for establishing the operating temperature of the electronic device.

7. Vehicle according to one of the claims 1 to 6, **characterized in that** the at least one air outlet (20) is located in such a way that the air current exiting the housing (12) strikes at least one window (22, 24) of the vehicle.

8. Vehicle according to one of the claims 1 to 7, **characterized in that** the at least one air inlet opening (18) has a cross-section that decreases towards the inside of housing (12).

9. Vehicle according to claim 8, **characterized in that** several air inlets (18) are arranged along an edge of the housing (12).

10. Vehicle according to claim 8 or 9, **characterized in that** the electronic device is permanently accommodated in housing (12).

11. Vehicle according to one of the claims 8 to 10, **characterized in that** the housing is designed as a docking station and the electronic device is a mobile device, which can be connectively plugged-into the docking station.

## Revendications

1. Véhicule pourvu :
- d'un habitacle ;
- d'un système de climatisation qui est adapté à produire des flux d'air thermorégulés dans l'habitacle ; et
- d'un boîtier (12), qui comprend au moins un orifice d'entrée d'air (18) qui est en liaison fluidique avec un conduit d'air (16) du système de climatisation, et au moins un orifice de sortie d'air (20) permettant de faire circuler un flux d'air thermorégulé à travers le boîtier (12) ;
- un dispositif électronique, qui est logé dans le boîtier (12) et autour duquel le flux d'air thermorégulé peut circuler,
**caractérisé en ce que** :
- la thermorégulation comprend un refroidissement et un chauffage ;
- pour la thermorégulation du dispositif électronique, seuls les flux d'air thermorégulés au moyen du système de climatisation par régulation de température et qui circulent à travers le boîtier (12) sont utilisés ; et
- le dispositif électronique est un système de vision indirect, qui est agencé à une position prédéfinie dans l'habitacle dans le champ de vision d'un conducteur du véhicule.

2. Véhicule selon la revendication 1, **caractérisé en ce que** la position prédéfinie se situe dans un pied avant (10) du véhicule.

3. Véhicule selon la revendication 1 ou 2, **caractérisé en ce que** la position prédéfinie se situe sur le tableau de bord du véhicule.

4. Véhicule selon l'une quelconque des revendications 1 à 3, **caractérisé en ce que** le boîtier (12) est relié d'un seul tenant à un élément du véhicule.

5. Véhicule selon l'une quelconque des revendications 1 à 4, **caractérisé en ce que** le boîtier (12) est relié de manière détachable à un élément du véhicule.

6. Véhicule selon l'une quelconque des revendications 1 à 5, **caractérisé en ce qu'**une température intérieure du boîtier (12) est une grandeur de réglage destinée à régler la température de fonctionnement.

7. Véhicule selon l'une quelconque des revendications 1 à 6, **caractérisé en ce que** le au moins un orifice de sortie d'air (20) est agencé de telle sorte que le flux d'air sortant du boîtier (12) afflue au moins sur une vitre (22, 24) du véhicule.

8. Véhicule selon l'une quelconque des revendications 1 à 7, **caractérisé en ce que** le au moins un orifice d'entrée d'air (18) possède une section transversale qui diminue à l'intérieur du boîtier (12).

9. Véhicule selon la revendication 8, **caractérisé en ce que** plusieurs orifices d'entrée d'air (18) sont agencés le long d'un bord du boîtier (12).

10. Véhicule selon la revendication 8 ou 9, **caractérisé en ce que** le dispositif électronique est intégré fixement dans le boîtier (12).

11. Véhicule selon l'une quelconque des revendications 8 à 10, **caractérisé en ce que** le boîtier est réalisé sous la forme d'une station d'accueil et le dispositif électronique est un dispositif mobile qui peut être accouplé à la station d'accueil.
